Europäisches Patentamt

European Patent Office

Office européen des brevets

(11) Publication number: **0 525 464 A1**

# EUROPEAN PATENT APPLICATION

(21) Application number: **92111680.2**

(22) Date of filing: **09.07.92**

(51) Int. Cl.5: **H01L 21/82**, H01L 21/314, H01L 27/108

(30) Priority: **30.07.91 US 737732**

(43) Date of publication of application:
**03.02.93 Bulletin 93/05**

(84) Designated Contracting States:
**DE FR GB**

(71) Applicant: **INTERNATIONAL BUSINESS MACHINES CORPORATION**
**Old Orchard Road**
**Armonk, N.Y. 10504(US)**

(72) Inventor: **Pan, Pai-Hung**
**2 Clove Court**
**Hopewell Junction, NY 12533(US)**

(74) Representative: **Jost, Ottokarl, Dipl.-Ing.**
**IBM Deutschland GmbH Intellectual Property**
**Dept. Schönaicher Strasse 220**
**W-7030 Böblingen(DE)**

(54) Dielectric capacitor film for dram cell and method of forming the same.

(57) An ultra thin triple layer dielectric film for use as a storage capacitor in a Dynamic Random Access Memory (DRAM) cell and a method of forming the same is disclosed. The thin dielectric film has an equivalent thickness $T_{eq}$ of no greater than about 7 nanometers. The capacitor film is prepared by forming a layer of silicon oxynitride $Si_xN_yO_z$ from either a thin film of silicon oxide $SiO_2$ situated on a substrate to which a nitridation process is applied or from direct nitridation of silicon deposits or a silicon substrate. Upon the oxynitride layer there is deposited a thin nitride layer, the top portion of which is subsequently oxidized at a high temperature for a short time to convert the top portion of the nitride layer into a thin silicon dioxide layer. The resulting structure comprises a oxynitride/nitride/dioxide dielectric having a low $T_{eq}$ (no greater than about 7 nanometers), and high capacitance. The ultra thin triple layer dielectric film can be used as a storage capacitor in a trench embodiment as well as a planar or stacked configuration mounted on a substrate.

fig. 1

## BACKGROUND OF THE INVENTION

### Field of Invention

The present invention relates generally to semiconductor memories and, more particularly, to dielectric films used to form a storage capacitor in a Dynamic Random Access Memory (DRAM) cell and a method of forming the same.

### Description of Prior Art

Thin film insulators are key materials in semiconductor integrated circuits, particularly in regard to their application as dielectrics for the storage capacitor of the so called "one device" Dynamic Random Access Memory (DRAM) cell. Typically, a thin dielectric film is thermally grown or deposited on a silicon substrate or wafer and then a metal or polysilicon electrode is deposited on top of the thin film to form the charge plate of the capacitor.

It is known in the art to form a storage capacitor with a triple layer dielectric film of silicon dioxide/silicon nitride/silicon dioxide. These capacitors are commonly described as having an O/N/O dielectric film. See for example Lu, U.S. Patent No. 4,649,625, Malhi, U.S. Patent No. 4,797,373, and Jillie, U.S. Patent No. 4,808,259.

The total charge of a capacitor (Q) is equal to the capacitance (C) multiplied by the voltage (V).

Q = CV

In order to reduce the voltage of a cell, it is necessary to increase the capacitance of the cell to maintain the same total charge within the cell.

It is known that capacitance (C) is related to the quotient of the surface area of the capacitor layer (A) divided by the equivalent thickness of the capacitor layer $T_{eq}$.

$$C \propto \frac{A}{T_{eq}}$$

$T_{eq}$ is related to the product of the physical thickness of the capacitor layer $T_p$ multiplied by the quotient of the dielectric constant of silicon dioxide over the equivalent dielectric constant of the capacitor layer $K_{eq}$.

$$T_{eq} \propto T_p \left( \frac{K_{sio_2}}{K_{eq}} \right) \propto T_p \left( \frac{3.9}{K_{eq}} \right)$$

Thus, in order to achieve increased capacitance (C), it is necessary to scale down the overall equivalent thickness of the dielectric film comprising the storage capacitor. This is accomplished by reducing the physical thickness $T_p$ and/or increasing the equivalent dielectric constant $K_{eq}$.

However, with the conventional silicon dioxide/silicon nitride/silicon dioxide (O/N/O) triple dielectric film and the known methods of depositing and oxidizing the O/N/O layers, it has not been possible to achieve a reliable ultra thin dielectric film with an equivalent thickness of no greater than about 7 nanometers (nm).

The difficulty in reducing the equivalent thickness $T_{eq}$ of the traditional O/N/O layer to no greater than about 7 nanometers is believed to be caused by the inability to sufficiently thin the physical thickness of the middle nitride layer when using known low pressure chemical vapor deposition techniques. Such known techniques cause the "thin" middle nitride layer to be discontinuous. When a reoxidation process is applied to the discontinuous middle nitride layer, the oxidant (i.e.: oxygen) will diffuse through "holes" in the discontinuous middle nitride layer and oxidize the silicon substrate. This will result in a significant increase in the equivalent thickness. Thus, the discontinuity of the "thin" nitride layer makes the necessary step of reoxidation of the layer virtually impossible.

Therefore, present technology does not provide a way to reduce the equivalent thickness of an O/N/O triple dielectric layer giving a high yield ultra thin storage capacitor. In order to have a storage capacitor triple dielectric film with an equivalent thickness of no greater than about 7 nanometers, a new approach is needed.

Barile, U.S. Patent No. 3,793,090, discloses a method of stabilizing the threshold voltage of a Field Effect Transistor (FET). The method calls for forming the gate dielectric by forming an oxide layer, depositing a nitride layer thereon and then annealing the nitride in oxygen at temperatures between 970 and 1150°C to form a thin layer of silicon oxynitride.

Abernathy, U.S. Patent No. 4,725,560 discloses a method of making a storage capacitor with a silicon oxynitride dielectric layer. The steps include depositing a silicon nitride layer by Low Pressure Chemical Vapor Deposition (LPCVD), annealing the deposited layer in wet oxygen or nitrogen; implanting arsenic ions through the layer to form an N-type region in the silicon substrate; annealing the resulting layers in wet oxygen between 700 and 1,000°C; and then forming an electrode thereon.

Ito, U.S. Patent No. 4,543,707, discloses a dual dielectric of stacked silicon oxynitride layers on a silicon substrate. The layers have different etch rates resulting from varying the N to O ratio. Selective etching is performed to form a through hole in the stacked layers.

Nozaki, U.S. Patent No. 4,282,270, discloses a method for forming an insulating film on the surface of a silicon substrate by directly converting a portion of the surface to silicon oxynitride. The film is formed by contacting the substrate with an ammonia gas and an oxygen-containing gas in a volume concentration of from 100-10,000 parts per million (ppm) based on molecular oxygen at a temperature of from 900 to 1,300°C.

"Formation of Thick $Si_3N_4$ or $Si_xO_yN_z$ on Si Substrate by Anodnitridization", IBM Tech. Disc. Bulletin., Vol. 19, No. 3 (1976), page 905, discloses a method of converting a surface of a silicon substrate to a silicon oxynitride film. The method involves anodizing the substrate with a HF solution and then heating the anodized solution at 800 to 1,300°C using a gas flow of ammonia and oxygen, or optionally also with nitrogen.

Hui, U.S. Patent No. 4,746,630, discloses a method for forming a field oxide layer. The method includes forming a thin oxide layer over the surface of a silicon substrate, then forming in succession a thin nitride layer, a thin oxide layer and a thick nitride layer. The layers are patterned to expose the surface of the substrate upon which the field oxide is formed.

Geipel, Jr., et al., U.S. Patent No. 4,631,219, discloses an oxygen-impervious pad structure which reduces the bird's beak profiles in semi-recessed oxide isolation regions comprising a sidewall of silicon oxide and an adjacent silicon nitride pad coated with a thick layer of oxynitride.

In general, there is no teaching in the prior art of an ultra thin triple layer dielectric film for use as a memory storage capacitor which has a equivalent thickness $T_{eq}$ of no greater than about 7 nanometers and which is comprised of contiguous layers of silicon oxynitride, silicon nitride and silicon dioxide ($Si_xO_yN_z/Si_3N_4/SiO_2$).

## SUMMARY OF THE INVENTION

The need for an ultra thin dielectric film having increased capacitance is satisfied in accordance with the principles of the present invention by providing a unique ultra thin dielectric film for use as a storage capacitor in a Dynamic Random Access Memory (DRAM) cell comprising a thin layer of silicon oxynitride, a thin layer of silicon nitride contiguous to said silicon oxynitride layer and a thin layer of silicon dioxide contiguous to said silicon nitride layer wherein the triple layer dielectric film has an equivalent thickness of no greater than about 7 nanometers.

The method for forming the inventive triple layer dielectric film for use as a storage capacitor in a Dynamic Random access Memory (DRAM) cell comprises the steps of forming a silicon oxynitride layer on a silicon substrate, said silicon oxynitride layer having an equivalent thickness of no greater than about 3 nanometers, then depositing a thin silicon nitride layer upon said oxynitride layer having an equivalent thickness of no greater than about 4 nanometers; and then oxidizing a portion of said nitride layer to form a silicon dioxide layer having an equivalent thickness of no greater than about 2 nanometers.

In particular, the ultra thin dielectric film can be formed wherein the silicon oxynitride layer is formed by nitridizing a silicon dioxide layer situated on a silicon substrate or by nitridation of either the silicon substrate surface or silicon deposits situated thereon.

It is a principle object of the invention to improve Dynamic Random Access Memory (DRAM) cell storage capacitors used in semiconductor devices.

It is a further object to increase the capacitance of the storage node comprised of dielectric films used in Dynamic Random Access Memory (DRAM) cells.

A principle advantage of the invention is a reduction in the equivalent thickness $T_{eq}$ of the dielectric film which results in increased capacitance.

A further advantage of the invention is to provide a dielectric film having an equivalent thickness of no greater than about 7 nanometers with high yield and good reliability manifested by very "tight" breakdown distributions and a high stress yield.

It has been found that the invention results in high yields of a silicon oxynitride/silicon nitride/silicon dioxide dielectric film having an equivalent thickness of no greater than about 7 nanometers having high charge storage capability and excellent reliability.

## BRIEF DESCRIPTION OF THE DRAWINGS

These and other objects, aspects, features and advantages of the present invention will be more readily understood from the following detailed description when read in conjunction with the accompanying drawings, in which:

Fig. 1 is a cross-sectional schematic view of a triple layer capacitor film of the present invention mounted on a silicon substrate having a planar configuration.

Fig. 2 is a cross-sectional schematic view of a triple layer capacitor film of the present invention mounted in a silicon substrate having a trench or node configuration.

Fig. 3     is a cross-sectional schematic view of a triple layer capacitor film of the present invention formed on a silicon substrate having a stacked storage node configuration.

Figs. 4a-c     are graphs showing the breakdown voltage distributions for a known silicon dioxide/silicon nitride (O/N) film with an equivalent thickness of about 8.2 nanometers.

Fig. 4d     is a table reporting equivalent thickness measurements $(T_{ox}(A))$ and other characterizing data for the same silicon dioxide/silicon nitride (O/N) film as shown in Figs. 4a-c showing an average equivalent thickness of about 8.2 nanometers.

Figs. 5a-c     are graphs showing the breakdown voltage distributions for a known silicon dioxide/silicon nitride/silicon dioxide (O/N/O) film with an equivalent thickness of about 8.6 nanometers.

Fig. 5d     is a table reporting equivalent thickness measurements $(T_{ox}(A))$ and other characterizing data for the same silicon dioxide/silicon nitride/silicon dioxide (O/N/O) film as shown in Figures 5a-c showing an average equivalent thickness of about 8.6 nanometers.

Figs. 6a-c     are graphs showing the breakdown voltage distributions for the inventive silicon oxynitride/silicon nitride/silicon dioxide film $(Si_xO_yN_z/Si_3N_4/SiO_2)$ with an equivalent thickness of about 5.7 nanometers.

Fig. 6d     is a table reporting equivalent thickness measurements $(T_{ox}(A))$ and other characterizing data for the inventive silicon oxynitride/silicon nitride/silicon dioxide film $(Si_xO_yN_z/Si_3N_4/SiO_2)$ as shown in Figs. 6a-c showing an average equivalent thickness of about 5.7 nanometers.

DETAILED DESCRIPTION OF THE PREFERRED EMBODIMENTS

There will now be described a triple layer dielectric film for use as a storage capacitor in a Dynamic Random Access Memory (DRAM) cell and method for forming the same.

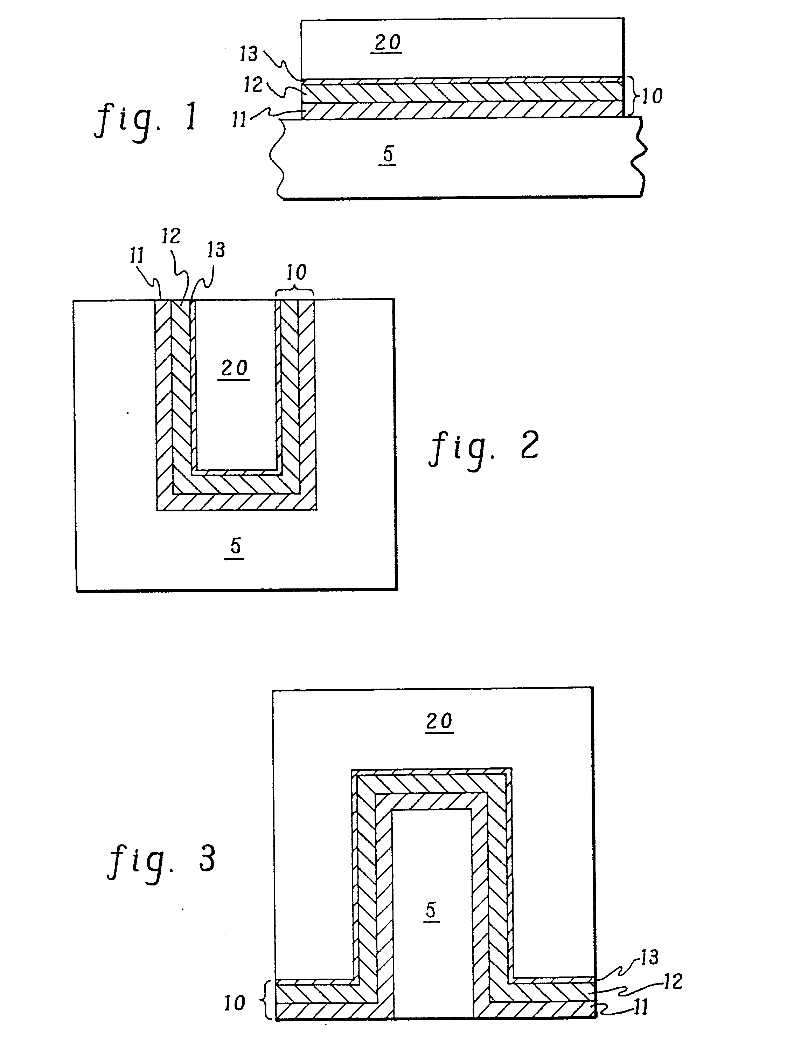

Referring to Figs. 1, 2 and 3, a novel triple dielectric film (10) is comprised of a thin silicon oxynitride layer (11), a thin layer of silicon nitride (12) contiguous to said silicon oxynitride thin layer (11), and a thin layer of silicon dioxide (13) contiguous to said silicon nitride layer (12), wherein the dielectric film (10) has an equivalent thickness of no greater than about 7 nanometers and preferably no greater than about 6 nanometers. The film (10) is mounted on a substrate or wafer (5) which is made of silicon or any suitable material having silicon deposits situated thereon. A conventional electrode (20) is mounted or positioned on or next to at least one layer of the film (10) and, preferably, next to the silicon dioxide layer (13) and is preferably made of polysilicon, but can also be made from a metal, a silicide, or other material conventionally used to form electrodes.

The dielectric film (10) has a physical thickness of no greater than about 12 nanometers which is comprised of the silicon oxynitride layer (11) having a physical thickness of no greater than about 4 nanometers, a silicon nitride layer (12) having a physical thickness of no greater than about 8 nanometers and preferably no greater than about 7 nanometers and a silicon dioxide layer (13) having a physical thickness of no greater than about 1 nanometer. From these values the equivalent thickness of each layer can be calculated according to the equations given above.

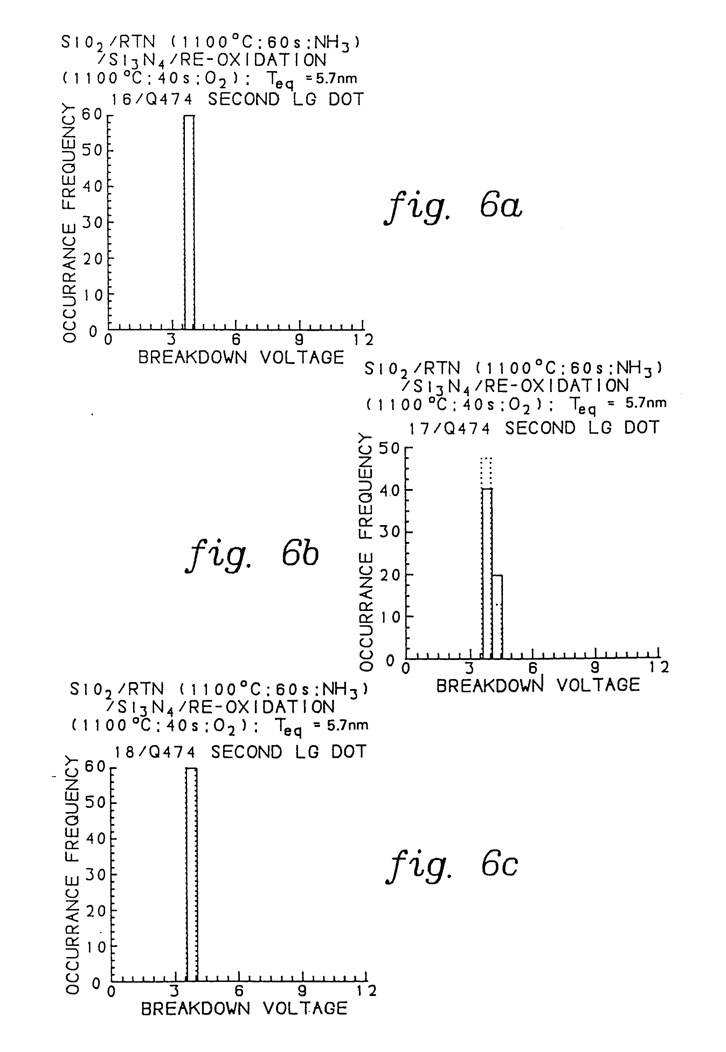

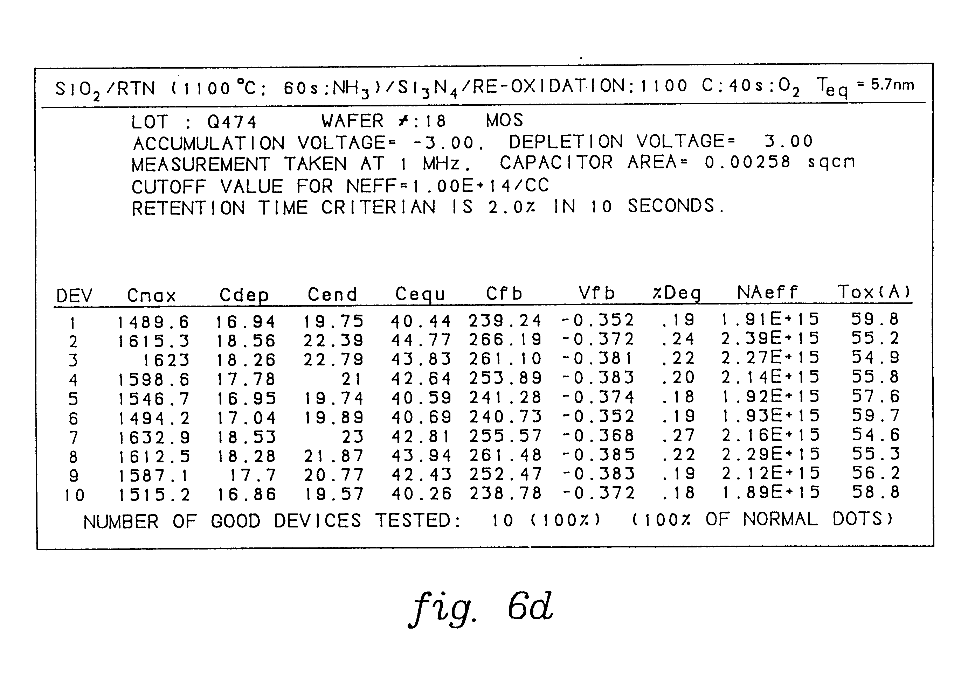

Fig. 6d shows the average equivalent thickness measurements of about 5.7 nanometers for the inventive dielectric film (10) taken at one Megahertz.

A method of forming the dielectric film (10) comprises the steps of forming a silicon oxynitride layer (11) on a substrate (5), then depositing a thin silicon nitride layer (12) contiguous to said oxynitride layer (11), and then oxidizing a portion of said nitride layer (12) to form a silicon dioxide layer (13).

The oxynitride layer (11) is formed by either depositing or growing a thin film of silicon dioxide with a physical thickness of no greater than about 4 nanometers on the substrate (5) and then applying a nitridation process to the silicon dioxide. The silicon dioxide film can be deposited either by a Low Pressure Chemical Vapor Deposition (LPCVD) Process or a Plasma Enhanced Chemical Vapor Deposition (PECVD) Process, as typically done by those knowledgeable in the art. The silicon dioxide can be "grown" on the substrate (5) either by applying an oxidation process typically used by those skilled in the art such as a Rapid Thermal Oxidation (RTO) Process, a Conventional Furnace Oxidation (CFO) Process or a Plasma Thermal Oxidation (PTO) Process. These types of processes are described in more detail below.

In order to convert the grown or deposited silicon dioxide to a silicon oxynitride layer (11), one of three nitridation processes may be used.

The preferred nitridation process is referred to as a Rapid Thermal Nitridation (RTN) Process. The Rapid Thermal Nitridation Process is a type of rapid thermal anneal which uses a high power lamp at a temperature range of between about 1,100-1,200°C in the presence of ammonia ($NH_3$) gas for 20-60 seconds. The high power lamp is capable of elevating the temperature of the underlying substrate (5) by 200°C/second. An anneal is a process which introduces elements into the film that are present in the ambient anneal gas.

A second suitable nitridation process is referred to as a Conventional Furnace Nitridation (CFN) Process. A CFN process heats the silicon dioxide or silicon layer using a conventional furnace or heating oven at a temperature of at least about 1,000°C for about 20-60 minutes in the presence of ammonia gas.

A third suitable third nitridation process which satisfactorily converts the silicon dioxide or silicon to $Si_xN_yO_z$ is known as a Plasma Thermal Nitridation (PTN) Process which, like the Conventional Furnace Nitridation (CFN) Process, uses a conventional furnace or heating oven in the presence of ammonia, but also supplies a Radio Frequency (RF) power source which provides electron bombardment to dissociate the ammonia molecule.

It is possible to avoid depositing or growing a silicon dioxide layer on the substrate (5) and, instead, treat the silicon substrate directly or other substrate with silicon deposits thereon with either the Rapid Thermal Nitridation (RTN) Process, the Conventional Furnace Nitridation (CFN) Process or the Plasma Thermal Nitridation (PTN) Process. Each such process will convert a top portion of the silicon substrate or the silicon deposits, if used, to silicon oxynitride.

The nitride layer (12) of the dielectric film (10) is deposited contiguous to the converted silicon oxynitride layer (11) by a Low Pressure Chemical Vapor Deposition (LPCVD) technique or the process as described, for instance, in Abernathy, U.S. Patent No. 4,725,560 or as otherwise known by those skilled in the art. It is desirable that the physical thickness of the nitride layer (12) be no greater than about 8 nanometers and preferably no greater than about 7 nanometers.

The layer of silicon dioxide or oxide layer (13) is formed by oxidizing the top portion of the nitride layer (12) by one of three oxidizing processes, such that the resultant silicon dioxide layer (13) has a physical thickness of no greater than about 2 nanometers.

The preferred oxidizing process is referred to as a Rapid Thermal Oxidation (RTO) Process which heats the nitride layer (12) to between about 1,100°-1,200°C by a high power lamp of the type described in the Rapid Thermal Nitridation (RTN) Process above, in the presence of oxygen gas for between 20-60 seconds.

A second oxidizing process is referred to as a Conventional Furnace Oxidation (CFO) Process which heats the nitride layer using a conventional furnace or heating oven to a temperature of at least about 1,000°C for about 20-60 minutes in the presence of oxygen gas.

A third oxidizing process is referred to as a Plasma Thermal Oxidation (PTO) Process which is identical to the Plasma Thermal Nitridation (PTN) Process described above, except that oxygen gas is used to treat the subject layer in place of ammonia gas.

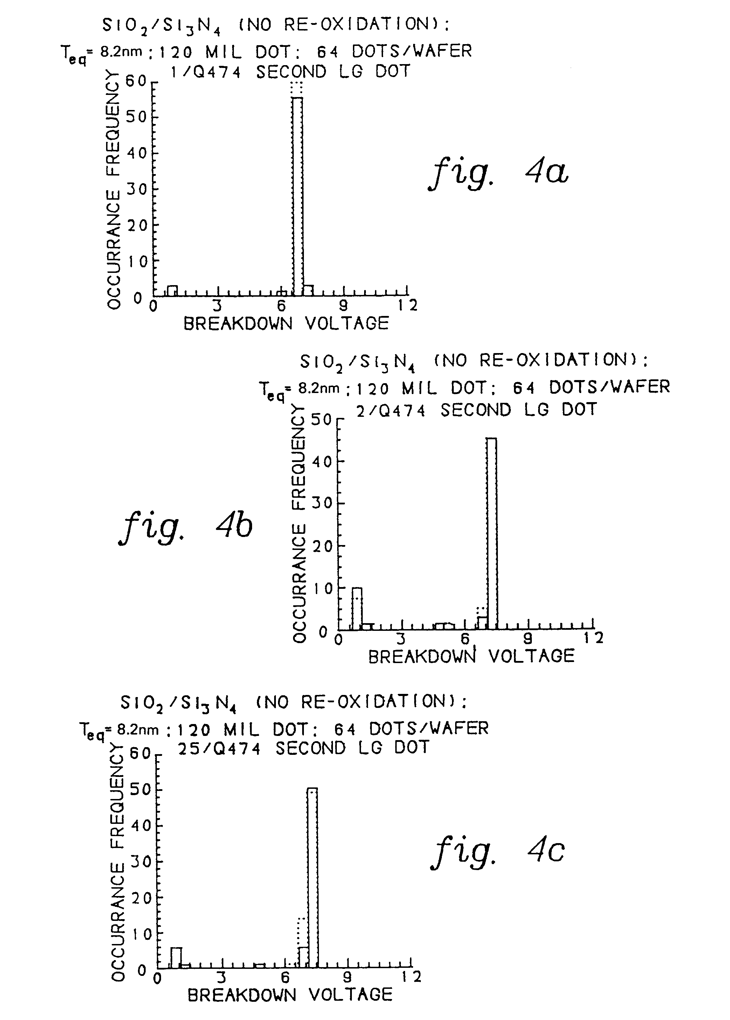

Referring to Figs. 4a-c, 5a-c and 6a-c, the value of the invention becomes more apparent.

It is known that the electrical field ($E_{field}$) of a capacitor equals the breakdown voltage (V) divided by the equivalent thickness $T_{eq}$ of the capacitor. The breakdown voltage is defined as the voltage measured across a dielectric film when the current is 10 microamps, and is not what is commonly considered a catastrophic dielectric breakdown by those skilled in the art.

$$E_{field} = \frac{V}{T_{eq}}$$

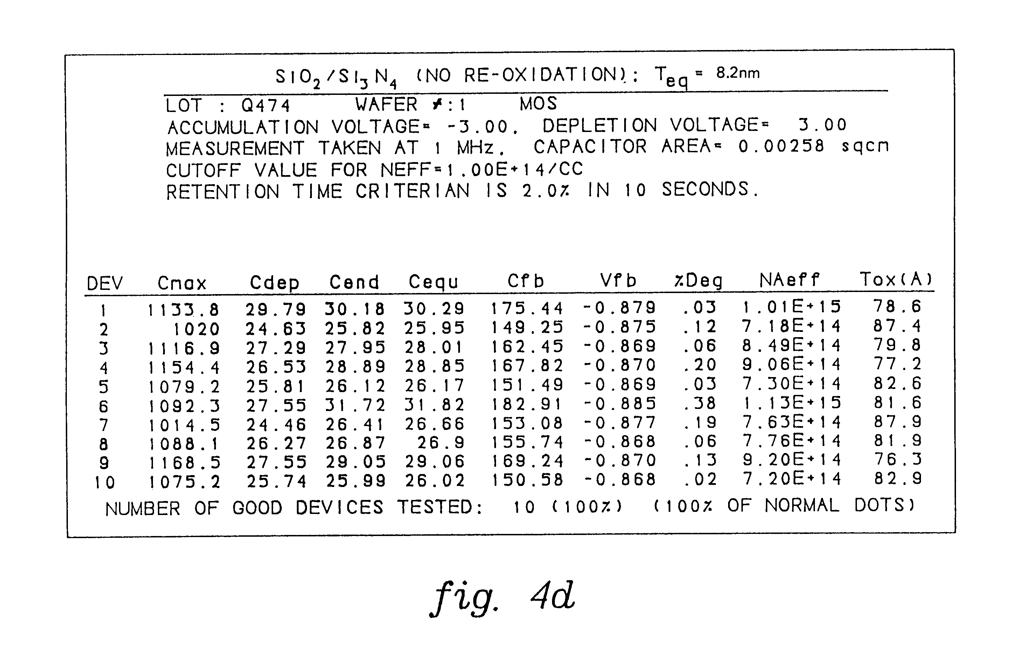

Figs. 4a-c show the breakdown voltage distributions for a dielectric film of $SiO_2/Si_3N_4$ (O/N). These graphs show several premature breakdown occurrences which indicate the presence of weak spots. Fig. 4d shows an average $T_{eq}$ ($T_{ox}(A)$) of about 8.2 nanometers for the film. The electrical field ($E_{field}$) for the film is, therefore, about 8.5 Megavolts per centimeter.

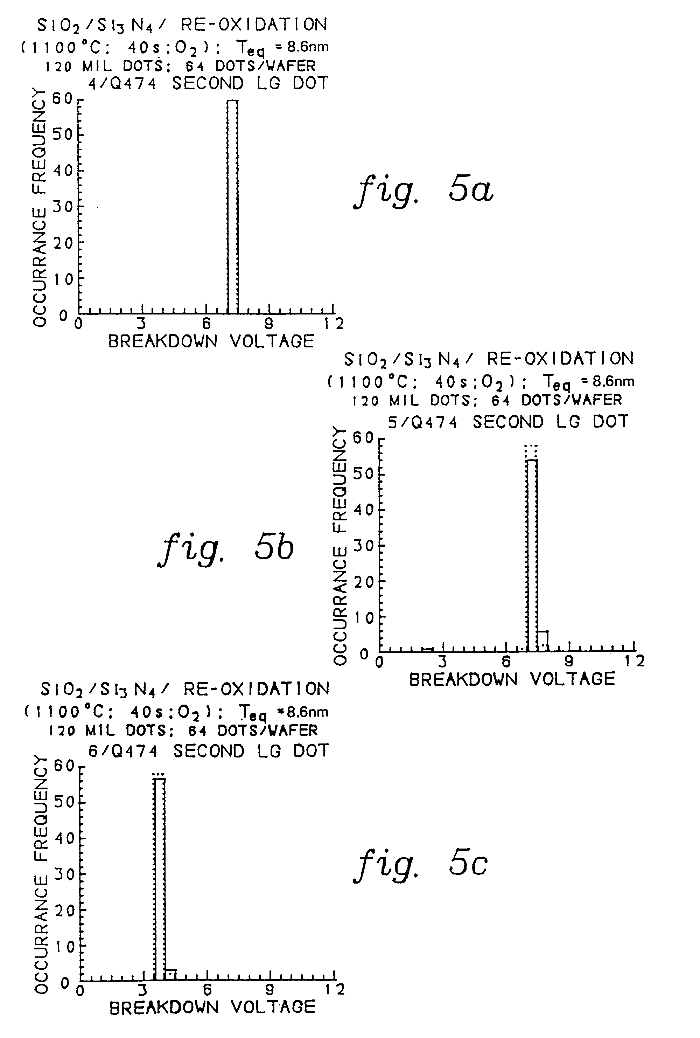

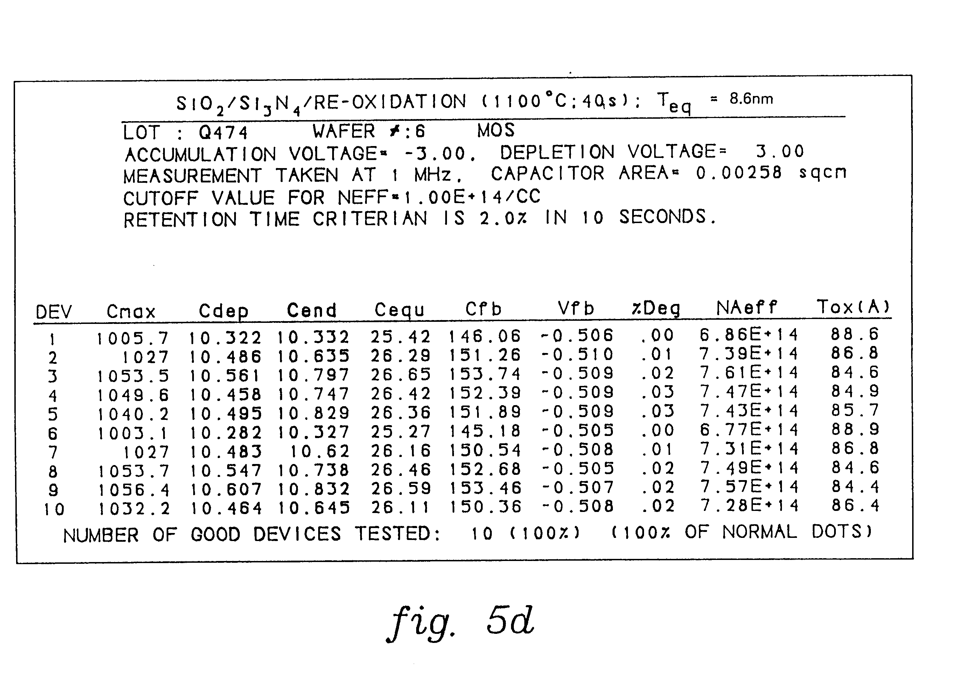

In Figs. 5a-c, the graphs for an O/N/O film show fewer premature breakdown occurrences which indicate better yield and reliability. Fig. 5d shows an average $T_{eq}$ of about 8.6 nanometers for the O/N/O film shown in Figs. 5a-c. The $E_{field}$ value for the O/N/O film is, therefore, about 8.1 Megavolts per centimeter.

Figs. 6a-d, show the breakdown voltage distributions and $T_{eq}$ for the inventive film. It is seen that the inventive film has no premature breakdowns as reported in the graphs at Figs. 6a-c. The $T_{eq}$ of the inventive film averages about 5.7 nanometers. Thus, the $E_{field}$ equals about 7.0 Megavolts per centimeter.

Therefore, the inventive film, while having an equivalent thickness no greater than about 7 nanometers has a comparable electrical field ($E_{field}$) to the traditional O/N/O film having a $T_{eq}$ of about 8.6 nanometers. When compared to an O/N film with a $T_{eq}$ of about 8.2 nanometers, the inventive film is superior in both its yield and reliability.

**Claims**

1. An ultra thin dielectric film (10) for use as a storage capacitor in a Dynamic Random Access Memory (DRAM) cell comprising:

   a thin layer (11) of silicon oxynitride;

   a thin layer (12) of silicon nitride contiguous to said silicon oxynitride thin layer (11); and

   a thin layer (13) of silicon dioxide contiguous to said silicon nitride layer (12) wherein the dielectric film has an equivalent thickness of no greater than about 7 nanometers.

2. An ultra thin dielectric film (10) according to claim 1 wherein the equivalent thickness of the dielectric (10) film is no greater than about 6 nanometers.

3. A method of forming an ultra thin dielectric film (10) for use as a storage capacitor in a Dynamic Random Access Memory (DRAM) cell comprising the steps of:

   forming a silicon oxynitride layer (11) on a substrate (5), said silicon oxynitride layer (11) having an equivalent thickness no greater than about 3 nanometers;

   then depositing a thin silicon nitride layer (12) contiguous to said oxynitride layer (11) having an equivalent thickness of no greater than about 4 nanometers; and

   then oxidizing a portion of said nitride layer (12) to form a silicon dioxide layer (13) having an equivalent thickness of no greater than about 2 nanometers.

4. A method of forming an ultra thin storage capacitor (Fig. 2; Fig. 3) for use in a Dynamic Random Access Memory (DRAM) cell comprising the steps of;

   forming an ultra thin dielectric film (10) according to claim 3; and

   then forming an electrode (20) on the silicon dioxide layer (13).

5. A storage capacitor (Fig. 2; Fig. 3) for use in a Dynamic Random Access Memory (DRAM) cell formed according to claim 4.

6. An ultra thin dielectric film (10) according to claim 1 wherein the silicon oxynitride layer (11) is a product of a nitridation process applied to a silicon dioxide layer situated on a silicon substrate (5).

7. An ultra thin dielectric film according to claim 1 wherein the silicon oxynitride layer (11) is a product of a nitridation process applied to silicon deposits situated on a substrate surface (5) or nitridation of a silicon substrate surface (5) directly.

8. An ultra thin dielectric film (10) according to claim 6 or 7 wherein said nitridation process is accomplished either by applying a Rapid Thermal Nitridation (RTN) Process, by a Conventional Furnace Nitridation (CFN) Process with ammonia gas or by applying a Plasma Thermal Nitridation (PTN) Process.

9. An ultra thin dielectric film (10) according to claim 1 wherein the silicon dioxide layer (13) is formed by applying an oxidation process which oxidizes a top portion of said silicon nitride layer (12).

10. An ultra thin dielectric film (10) according to claim 9 wherein said oxidation process is accomplished either by applying a Rapid Thermal Oxidation (RTO) Process conducted at a high temperature of between about 1,100° - 1,200° C for about 20-60 seconds, or by applying a Conventional Furnace Oxidation (CFO) Process, or by applying a Plasma Thermal Oxidation (PTO) Process in the presence of oxygen gas.

11. A method of forming an ultra thin storage capacitor according to claim 4 wherein the step of forming the silicon oxynitride layer (11) is accomplished by nitridizing a silicon dioxide layer situated on a silicon substrate (5).

12. A method of forming an ultra thin storage capacitor according to claim 4 wherein the step of forming the silicon oxynitride layer (11) is accomplished by nitridizing silicon dioxide deposits situated on a substrate surface (5) or nitridizing a silicon substrate surface (5) directly.

13. A method of forming an thin dielectric film according to claim 11 or 12 wherein said nitridation process is accomplished either by applying a Rapid Thermal Nitridation (RTN) Processor, by a Conventional Furnace Nitridation (CFN) Process with ammonia gas, or by applying a Plasma Thermal Nitridation (PTN) Process.

14. A method for forming an ultra thin dielectric film according to claim 3 wherein said oxidizing of said nitride layer portion is accomplished either by applying a Rapid Thermal Oxidation (RTO) Process conducted at a temperature of between about 1,100°-1,200°C for about 20-60 seconds, or by applying a Conventional Furnace Oxidation Anneal (CFO) Process, or by applying a Plasma Thermal Oxidation.

fig. 1

fig. 2

fig. 3

$SIO_2/SI_3N_4$ (NO RE-OXIDATION):
$T_{eq}$= 8.2nm ; 120 MIL DOT: 64 DOTS/WAFER
1/Q474 SECOND LG DOT

*fig. 4a*

$SIO_2/SI_3N_4$ (NO RE-OXIDATION):
$T_{eq}$= 8.2nm ; 120 MIL DOT: 64 DOTS/WAFER
2/Q474 SECOND LG DOT

*fig. 4b*

$SIO_2/SI_3N_4$ (NO RE-OXIDATION):
$T_{eq}$= 8.2nm ; 120 MIL DOT: 64 DOTS/WAFER
25/Q474 SECOND LG DOT

*fig. 4c*

$SiO_2/Si_3N_4$ (NO RE-OXIDATION): $T_{eq}$ = 8.2nm

LOT : Q474      WAFER #:1      MOS
ACCUMULATION VOLTAGE= -3.00.  DEPLETION VOLTAGE=  3.00
MEASUREMENT TAKEN AT 1 MHz.  CAPACITOR AREA= 0.00258 sqcn
CUTOFF VALUE FOR NEFF=1.00E+14/CC
RETENTION TIME CRITERIAN IS 2.0% IN 10 SECONDS.

| DEV | Cmax | Cdep | Cend | Cequ | Cfb | Vfb | %Deg | NAeff | Tox(A) |
|-----|------|------|------|------|-----|-----|------|-------|--------|
| 1 | 1133.8 | 29.79 | 30.18 | 30.29 | 175.44 | -0.879 | .03 | 1.01E+15 | 78.6 |
| 2 | 1020 | 24.63 | 25.82 | 25.95 | 149.25 | -0.875 | .12 | 7.18E+14 | 87.4 |
| 3 | 1116.9 | 27.29 | 27.95 | 28.01 | 162.45 | -0.869 | .06 | 8.49E+14 | 79.8 |
| 4 | 1154.4 | 26.53 | 28.89 | 28.85 | 167.82 | -0.870 | .20 | 9.06E+14 | 77.2 |
| 5 | 1079.2 | 25.81 | 26.12 | 26.17 | 151.49 | -0.869 | .03 | 7.30E+14 | 82.6 |
| 6 | 1092.3 | 27.55 | 31.72 | 31.82 | 182.91 | -0.885 | .38 | 1.13E+15 | 81.6 |
| 7 | 1014.5 | 24.46 | 26.41 | 26.66 | 153.08 | -0.877 | .19 | 7.63E+14 | 87.9 |
| 8 | 1088.1 | 26.27 | 26.87 | 26.9 | 155.74 | -0.868 | .06 | 7.76E+14 | 81.9 |
| 9 | 1168.5 | 27.55 | 29.05 | 29.06 | 169.24 | -0.870 | .13 | 9.20E+14 | 76.3 |
| 10 | 1075.2 | 25.74 | 25.99 | 26.02 | 150.58 | -0.868 | .02 | 7.20E+14 | 82.9 |

NUMBER OF GOOD DEVICES TESTED:  10 (100%)  (100% OF NORMAL DOTS)

*fig. 4d*

fig. 5a

$SiO_2 / Si_3 N_4 /$ RE-OXIDATION
$(1100°C: 40s: O_2): T_{eq} = 8.6nm$
120 MIL DOTS: 64 DOTS/WAFER
4/Q474 SECOND LG DOT

fig. 5b

$SiO_2 / Si_3 N_4 /$ RE-OXIDATION
$(1100°C: 40s: O_2): T_{eq} = 8.6nm$
120 MIL DOTS: 64 DOTS/WAFER
5/Q474 SECOND LG DOT

fig. 5c

$SiO_2 / Si_3 N_4 /$ RE-OXIDATION
$(1100°C: 40s: O_2): T_{eq} = 8.6nm$
120 MIL DOTS: 64 DOTS/WAFER
6/Q474 SECOND LG DOT

$SIO_2/SI_3N_4/RE\text{-}OXIDATION$ (1100°C;4Qs); $T_{eq}$ = 8.6nm

LOT : Q474      WAFER *:6      MOS
ACCUMULATION VOLTAGE= -3.00,  DEPLETION VOLTAGE= 3.00
MEASUREMENT TAKEN AT 1 MHz,  CAPACITOR AREA= 0.00258 sqcm
CUTOFF VALUE FOR NEFF=1.00E+14/CC
RETENTION TIME CRITERIAN IS 2.0% IN 10 SECONDS.

| DEV | Cmax | Cdep | Cend | Cequ | Cfb | Vfb | %Deg | NAeff | Tox(A) |
|---|---|---|---|---|---|---|---|---|---|
| 1 | 1005.7 | 10.322 | 10.332 | 25.42 | 146.06 | -0.506 | .00 | 6.86E+14 | 88.6 |
| 2 | 1027 | 10.486 | 10.635 | 26.29 | 151.26 | -0.510 | .01 | 7.39E+14 | 86.8 |
| 3 | 1053.5 | 10.561 | 10.797 | 26.65 | 153.74 | -0.509 | .02 | 7.61E+14 | 84.6 |
| 4 | 1049.6 | 10.458 | 10.747 | 26.42 | 152.39 | -0.509 | .03 | 7.47E+14 | 84.9 |
| 5 | 1040.2 | 10.495 | 10.829 | 26.36 | 151.89 | -0.509 | .03 | 7.43E+14 | 85.7 |
| 6 | 1003.1 | 10.282 | 10.327 | 25.27 | 145.18 | -0.505 | .00 | 6.77E+14 | 88.9 |
| 7 | 1027 | 10.483 | 10.62 | 26.16 | 150.54 | -0.508 | .01 | 7.31E+14 | 86.8 |
| 8 | 1053.7 | 10.547 | 10.738 | 26.46 | 152.68 | -0.505 | .02 | 7.49E+14 | 84.6 |
| 9 | 1056.4 | 10.607 | 10.832 | 26.59 | 153.46 | -0.507 | .02 | 7.57E+14 | 84.4 |
| 10 | 1032.2 | 10.464 | 10.645 | 26.11 | 150.36 | -0.508 | .02 | 7.28E+14 | 86.4 |

NUMBER OF GOOD DEVICES TESTED:  10 (100%)  (100% OF NORMAL DOTS)

*fig. 5d*

$SiO_2/RTN$ $(1100\,^{\circ}C:60s:NH_3)$
$/Si_3N_4/RE-OXIDATION$
$(1100\,^{\circ}C:40s:O_2)$: $T_{eq}$ = 5.7nm
16/Q474 SECOND LG DOT

fig. 6a

$SiO_2/RTN$ $(1100\,^{\circ}C:60s:NH_3)$
$/Si_3N_4/RE-OXIDATION$
$(1100\,^{\circ}C:40s:O_2)$: $T_{eq}$ = 5.7nm
17/Q474 SECOND LG DOT

fig. 6b

$SiO_2/RTN$ $(1100\,^{\circ}C:60s:NH_3)$
$/Si_3N_4/RE-OXIDATION$
$(1100\,^{\circ}C:40s:O_2)$: $T_{eq}$ = 5.7nm
18/Q474 SECOND LG DOT

fig. 6c

EP 0 525 464 A1

$SiO_2$/RTN (1100 °C: 60s:$NH_3$)/$Si_3N_4$/RE-OXIDATION:1100 C:40s:$O_2$  $T_{eq}$ = 5.7nm

LOT : Q474      WAFER #:18    MOS
ACCUMULATION VOLTAGE= -3.00.  DEPLETION VOLTAGE=  3.00
MEASUREMENT TAKEN AT 1 MHz.  CAPACITOR AREA= 0.00258 sqcm
CUTOFF VALUE FOR NEFF=1.00E+14/CC
RETENTION TIME CRITERIAN IS 2.0% IN 10 SECONDS.

| DEV | Cmax | Cdep | Cend | Cequ | Cfb | Vfb | %Deg | NAeff | Tox(A) |
|---|---|---|---|---|---|---|---|---|---|
| 1 | 1489.6 | 16.94 | 19.75 | 40.44 | 239.24 | -0.352 | .19 | 1.91E+15 | 59.8 |
| 2 | 1615.3 | 18.56 | 22.39 | 44.77 | 266.19 | -0.372 | .24 | 2.39E+15 | 55.2 |
| 3 | 1623 | 18.26 | 22.79 | 43.83 | 261.10 | -0.381 | .22 | 2.27E+15 | 54.9 |
| 4 | 1598.6 | 17.78 | 21 | 42.64 | 253.89 | -0.383 | .20 | 2.14E+15 | 55.8 |
| 5 | 1546.7 | 16.95 | 19.74 | 40.59 | 241.28 | -0.374 | .18 | 1.92E+15 | 57.6 |
| 6 | 1494.2 | 17.04 | 19.89 | 40.69 | 240.73 | -0.352 | .19 | 1.93E+15 | 59.7 |
| 7 | 1632.9 | 18.53 | 23 | 42.81 | 255.57 | -0.368 | .27 | 2.16E+15 | 54.6 |
| 8 | 1612.5 | 18.28 | 21.87 | 43.94 | 261.48 | -0.385 | .22 | 2.29E+15 | 55.3 |
| 9 | 1587.1 | 17.7 | 20.77 | 42.43 | 252.47 | -0.383 | .19 | 2.12E+15 | 56.2 |
| 10 | 1515.2 | 16.86 | 19.57 | 40.26 | 238.78 | -0.372 | .18 | 1.89E+15 | 58.8 |

NUMBER OF GOOD DEVICES TESTED:  10 (100%)  (100% OF NORMAL DOTS)

*fig. 6d*

European Patent
Office

EUROPEAN SEARCH REPORT

Application Number

EP    92 11 1680
Page 1

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| P,X | DE-A-4 132 820 (MITSUBISHI DENKI K.K.) <br> * column 6, line 42 - line 61; figures * <br> * column 9, line 33 - line 65 * <br> --- | 1-14 | H01L21/82 <br> H01L21/314 <br> H01L27/108 |
| X | APPLIED PHYSICS LETTERS <br> vol. 55, no. 22, 27 November 1989, NEW YORK US <br> pages 2313 - 2315 <br> W. TING ET AL. 'Thin stacked oxide/nitride/oxide dielectrics formation by in situ multiple reactive rapid thermal processing' <br> * the whole document * <br> --- | 1-14 | |
| X | PATENT ABSTRACTS OF JAPAN <br> vol. 13, no. 164 (E-745)19 April 1989 <br> & JP-A-63 316 465 ( HITACHI LTD ) 23 December 1988 <br> * abstract * <br> --- | 1-14 | |
| A | EP-A-0 384 031 (MASTUSHITA ELECTRIC INDUSTRIAL CO.) <br> * abstract; figures * <br> --- | 1-14 | TECHNICAL FIELDS SEARCHED (Int. Cl.5 ) <br><br> H01L |
| A | GB-A-2 237 931 (SAMSUNG ELECTRONICS CO) <br> * abstract; figures * <br> --- | 1-14 | |
| A | JAPANESE JOURNAL OF APPLIED PHYSICS, SUPPLEMENTS EXTENDED ABSTRACTS OF THE 22TH CONFERENCE ON SOLID STATE DEVICES AND MATERIALS (1990) 1990, TOKYO JA <br> pages 159 - 162 , XP178031 <br> HISASHI FUKUDA ET AL. 'Highly Reliable Thin Nitrided SiO2 Films Formed by Rapid Thermal Processing in an N2O Ambient' <br> * abstract; figures * <br> --- | 1-14 | |

-/--

The present search report has been drawn up for all claims

| Place of search | Date of completion of the search | Examiner |
|---|---|---|
| THE HAGUE | 09 NOVEMBER 1992 | SINEMUS M. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)

European Patent
Office

EUROPEAN SEARCH REPORT

Application Number

EP    92 11 1680
Page 2

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A | PATENT ABSTRACTS OF JAPAN<br>vol. 4, no. 52 (E-7)18 April 1980<br>& JP-A-55 022 863 ( NEC CORP ) 18 February 1980<br>* abstract * | 1-14 | |
| | ----- | | |
| | | | TECHNICAL FIELDS SEARCHED (Int. Cl.5 ) |

The present search report has been drawn up for all claims

| Place of search | Date of completion of the search | Examiner |
|---|---|---|
| THE HAGUE | 09 NOVEMBER 1992 | SINEMUS M. |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

.................................................................................................
& : member of the same patent family, corresponding
   document

EPO FORM 1503 03.82 (P0401)